# EUROPEAN PATENT APPLICATION

(11) **EP 2 623 885 A1**
(43) Date of publication of application: **07.08.2013**
(21) Application number: 11829159.0
(22) Date of filing: 28.09.2011
(51) Int. Cl.: F24J 2/10, B32B 27/00, B32B 27/18, G02B 1/10, G02B 5/08, H01L 31/052

(54) **FILM MIRROR FOR SOLAR POWER GENERATION, PROCESS FOR MANUFACTURING FILM MIRROR FOR SOLAR POWER GENERATION, AND REFLECTION DEVICE FOR SOLAR POWER GENERATION**

(30) Priority: 01.10.2010 JP 2010223549
(71) Applicant: Konica Minolta Opto, Inc., Hachioji-shi, Tokyo 192-8505 (JP)
(72) Inventor: YONEZAKI, Ayumi, Hachioji-shi Tokyo 192-8505 (JP)
(74) Representative: Gille Hrabal
(86) International application number: PCT/JP2011/072146
(87) International publication number: WO 2012/043606

(57) **Abstract**

A film mirror for use in solar power generation, comprising a hard coat layer, a resin layer and a reflective layer in this order, wherein the hard coat layer and the resin layer are arranged adjacent to each other, and wherein the film mirror is characterized in that the hard coat layer contains a triazine-type UV absorbent or an inorganic UV absorbent.

## Description

### TECHNICAL FIELD

The present invention relates to a film mirror for solar thermal power generation, a method for manufacturing the film mirror for solar thermal power generation, and a reflection device for solar thermal power generation using the film mirror.

### BACKGROUND ART

Examples of the currently studied alternative energies for fossil fuel energies such as oil and natural gas energies include coal, biomass, and nuclear energies, and natural energies such as wind and solar energies. Among these alternative energies, solar energy is believed to be the most stable and abundant natural energy. Although solar energy is a significantly promising alternative energy, it has disadvantages of (1) low energy density and (2) difficulties in storage and transport, from the viewpoint of its utilization.

In order to overcome the disadvantage of its low energy density, collecting solar energy with a huge reflection device has been proposed. Glass mirrors have been used for reflection devices in view of exposure to severe environmental conditions such as ultraviolet radiation and heat from sunlight, wind and rain, and sandstorms. Although glass mirrors are highly durable for environments, they have disadvantages such as damage during transport and significantly high weight which leads to high plant construction costs for providing necessary strength of mounts on which the mirrors are installed.

To solve such problems, a method of replacing a glass mirror with a reflective resin sheet has been studied. However, the resin used was susceptible to external environment, and the specular reflectance decreases during long-term irradiation with sunlight when a metal such as silver is used in the reflective layer.

From the viewpoint of high reflectance for the purpose of solving these problems above and concentrating sunlight, a method has been disclosed of adding a great amount of a benzotriazole ultraviolet absorber (hereinafter also referred to as a UV absorber) to the resin layer disposed on a light-incident side remote from the silver reflective layer to inhibit the hard coat layer from whitening through photodegradation by UV light (see, for example, Patent Literature 1).

The method described in Patent Literature 1 above, however, does not in any way provide weather resistance enough to prevent the resin layer from deteriorating by irradiation with sunlight, leading to delamination between the layers and decrease in the reflectance.

### PRIOR ART DOCUMENTS

### PATENT LITERATURE

Patent Literature 1: U.S. Patent No. 7507776

### SUMMARY OF THE INVENTION

### PROBLEM TO BE SOLVED BY THE INVENTION

An object of the present invention is to provide a film mirror which has a high specular reflectance, without delamination even after long-term irradiation with sunlight, particularly a film mirror for solar thermal power generation, without delamination between the hard coat layer and the resin layer adjoining the hard coat layer.

### MEANS TO SOLVE THE PROBLEM

The present inventor, who has extensively studied to solve such problems, has found that the deterioration of the resin layer which constitutes the film mirror for solar thermal power generation is caused by ultraviolet decomposition of any small molecular weight component of the resin, remaining polymerization initiators and remaining monomer contained in the resin layer. Moreover, the inventor has found that the ultraviolet rays which decompose these components are ultraviolet light from the UV-A range (320 to 400 nm) to the UV-B range (290 to 320 nm), in particular the ultraviolet light from the UV-B range (290 to 320 nm).

The inventor has also found that use of the benzotriazole UV absorber is not enough to block the light from the UV-B range. Furthermore, the inventor has found that the benzotriazole UV absorber is readily degraded by the radiation in the UV-B range, and has impaired its ability to block the radiation in the UV-A range during large amounts of ultraviolet irradiation. Then, attempts have been made to use triazine compounds which have high absorptive properties for the radiation in the UV-B range (290 to 320 nm), and are less prone to be degraded even by the light from the UV-B range as a UV absorber, and have successfully prevented the deterioration of the resin layer, prevented delamination between the hard coat layer and the resin layer adjoining the hard coat layer, and prevented a decrease in the specular reflectance.

The problems to be addressed by the present invention may be solved by the configurations below.

1. A film mirror for solar thermal power generation including, in sequence, a hard coat layer, a resin layer and a reflective layer, which hard coat layer adjoins the resin layer, wherein the hard coat layer contains a triazine UV absorber or an inorganic UV absorber.

2. The film mirror for solar thermal power generation of above 1, wherein the hard coat layer contains 0.1 to 5% by mass of an antioxidant on the basis of a resin solid content.

3. The film mirror for solar thermal power generation of above 1 or 2, wherein the hard coat layer contains the triazine UV absorber and the inorganic UV absorber.

4. The film mirror for solar thermal power generation of any one of above 1 to 3, wherein the hard coat layer contains 0.1 to 10% by mass of the triazine UV absorber on the basis of the resin solid content.

5. The film mirror for solar thermal power generation of any one of above 1 to 4, wherein the hard coat layer contains 1 to 50% by mass of the inorganic UV absorber, and the inorganic UV absorber is a titanium oxide, a zinc oxide, a cerium oxide or an iron oxide.

6. The film mirror for solar thermal power generation of any one of above 1 to 5, wherein the inorganic UV absorber is a fine particulate absorber having a number average particle size of 10 nm to 100 nm.

7. The film mirror for solar thermal power generation of any one of above 1 to 6, wherein the inorganic UV absorber has a coating layer on its surface.

8. The film mirror for solar thermal power generation of any one of above 1 to 7, wherein the hard coat layer comprises a UV-cured acrylic resin.

9. The film mirror for solar thermal power generation of any one of above 2 to 8, wherein the antioxidant is a hindered amine compound.

10. A method for manufacturing the film mirror for solar thermal power generation of any one of above 1 to 9 including the reflective layer, the method comprising depositing silver to form the reflective layer.

11. A reflection device for solar thermal power generation comprising the film mirror for solar thermal power generation of any one of above 1 to 9 and a metal support, the film mirror being bonded to the metal support body with an adhesive layer.

### ADVANTAGEOUS EFFECTS OF INVENTION

The present invention can provide a film mirror for solar thermal power generation which does not cause delamination between the layers even after long-term irradiation with sunlight and has a high specular reflectance.

### DESCRIPTION of EMBODIMENTS

### (Film mirror for solar thermal power generation)

The film mirror for solar thermal power generation includes a hard coat layer, a resin layer and a reflective layer in sequence, wherein the hard coat layer adjoins the resin layer. The reflective layer is preferably a metal layer formed on a substrate, and an anchor layer is preferably disposed on the substrate before the formation of the metal layer to improve the adhesion between the substrate and the metal layer. In addition, since the metal layer is easily corroded by sunlight and moisture, a corrosion inhibiting layer containing a corrosion inhibitor is preferably disposed on the metal layer.

### (Reflection device for solar thermal power generation)

The reflection device for solar thermal power generation can be produced by laminating the film mirror for solar thermal power generation with an adhesive on the support body made of an aluminum plate, for example, the substrate being designed to regularly reflect sunlight in a target direction.

### (Hard coat layer)

The film mirror for solar thermal power generation of the present invention includes a hard coat layer as the outermost layer. The hard coat layer according to the present invention is disposed to prevent scratching and to block ultraviolet radiation.

The hard coat layer contains a triazine UV absorber or an inorganic UV absorber to block ultraviolet radiation.

The hard coat layer can be produced with a binder, such as acrylic resins, urethane resins, melamine resins, epoxy resins, organic silicate compounds, or silicone resins, by UV curing or thermal curing. In the present invention, the hard coat layer is preferably produced by UV curing in order to ensure the flatness of the lower resin substrate in particular. UV-curable acrylic resins are preferably used in the present invention in terms of hardness, durability and the like in particular.

In addition to resins made by UV or thermal curing, the hard coat layer may include a thermoplastic resin.

The resin solid component in the hard coat layer refers to a solid resin contained in the hard coat layer and a polymerizable component converted into solid resins by UV curing or thermosetting. The polymerizable component refers to polymerizable monomers and oligomers.

### (UV-curable acrylic resin)

The UV-curable acrylic resin is a composition including a polyfunctional acrylate, acrylic oligomer, or reactive diluent as a polymerizable curing component. The composition can optionally contain other additives, such as photoinitiators, photosensitizers, thermal polymerization initiators, and modifiers.

Examples of the polyfunctional acrylate include (meth)acrylate resins primarily composed of, for example, trimethylolpropane tri(meth)acrylate, trimethylolpropane tris(hydroxyethyl(meth)acrylate), tris(2-hydroxyethyl)isocyanurate tri(meth)acrylate, pentaerythritol tri(meth)acrylate, pentaerythritol tetra(meth)acrylate, dipentaerythritol hexa(meth)acrylate, and polyfunctional urethane (meth)acrylate.

The polyfunctional urethane (meth)acrylate used here is a compound having a urethane bond and at least two (meth)acryloyl groups, which is prepared, for example, by addition reaction of a compound having one hydroxy group and at least one (meth)acryloyl group in its molecule, such as trimethylolpropane di(meth)acrylate and pentaerythritol tri(meth)acrylate, to a polyisocyanate having at least two isocyanato groups (-NCO) in its molecule, such as isophorone diisocyanate and hexamethylene diisocyanate.

The polyfunctional acrylates may be used alone or in combination of two or more of them. In addition, the polyfunctional urethane (meth)acrylate can also be used in combination with a polyfunctional (meth)acrylate having no urethane bond as mentioned above.

Commercially available polyfunctional acrylates can be advantageously used. Specific examples of the commercially available polyfunctional acrylates include KAYARAD DPHA (available from Nippon Kayaku Co., Ltd.), KAYARAD DPCA-20 (Nippon Kayaku Co., Ltd.), KAYARAD DPCA-30 (Nippon Kayaku Co., Ltd.), KAYARAD DPCA-60 (Nippon Kayaku Co., Ltd.), KAYARAD DPCA-120 (Nippon Kayaku Co., Ltd.), KAYARAD D-310 (Nippon Kayaku Co., Ltd.), KAYARAD D-330 (Nippon Kayaku Co., Ltd.), KAYARAD PET-30 (Nippon Kayaku Co., Ltd.), KAYARAD GPO-303 (Nippon Kayaku Co. , Ltd.), KAYARAD TMPTA (Nippon Kayaku Co., Ltd.), KAYARAD THE-330 (Nippon Kayaku Co., Ltd.) and KAYARAD TPA-330 (Nippon Kayaku Co., Ltd.), and Aronix M-315 (available from TOAGOSEI Co., Ltd.) and Aronix M-325 (TOAGOSEI Co., Ltd.).

The UV-curable resin as mentioned above is usually used in the form of an admixture with a photopolymerization initiator. Commercially available photopolymerization initiator can be advantageously used such as IRGACURE 907 (available from Ciba Japan K.K.) and IRGACURE 184 (Ciba Japan K.K.), and Lucirin TPO (available from BASF).

Fine particulate silica may be added to the UV-curable resin from the viewpoint of obtaining a hard coat layer having sufficiently high hardness and being capable of sufficiently inhibiting curling caused by curing shrinkage. Examples of the fine particulate silica include powdery silica and colloidal silica, and silica having an average particle size within the range of 0.01 to 20 µm is advantageously used. The fine particulate silica preferably does not affect the optical transparency of the hard coat film; therefore, the fine particulate silica preferably has a primary particle size within the range of 10 to 350 nm and more preferably within the range of 10 to 50 nm. The average particle size of the fine particulate silica as mentioned above can be measured, for example, by transmission electron microscopy. The primary particle size of the fine particulate silica can be measured from its dispersion in a solvent such as isopropyl alcohol, by techniques such as Coulter particle size distribution measurement, laser diffraction and scattering, and dynamic light scattering. Among them, the most common is Coulter particle size distribution measurement.

The fine particulate silica may have a spherical, hollow, porous, rod, plate, fiber, or amorphous shape. Preferred is spherical silica, to advantageously disperse the fine particulate silica in the ultraviolet curable resin without aggregation. Moreover, from the viewpoint of maintaining the hardness and flatness of the hard coat layer 3, the fine particulate silica has desirably a specific surface area within the range of 0.1 to 3000 m²/g, more preferably 1 m²/g or more, and further more preferably 10 m²/g or more, and more preferably 1500 m²/g or less.

Commercially available fine particulate silica can be advantageously used. Examples of the commercially available fine particulate colloidal silica include methanol silica sol (available from Nissan Chemical Industries, Ltd.), IPA-ST (Nissan Chemical Industries, Ltd.), MEK-ST (Nissan Chemical Industries, Ltd.), NBA-ST (Nissan Chemical Industries, Ltd.), XBA-ST (Nissan Chemical Industries, Ltd.), DMAC-ST (Nissan Chemical Industries, Ltd.), ST-UP (Nissan Chemical Industries, Ltd.), ST-OUP (Nissan Chemical Industries, Ltd.), ST-20 (Nissan Chemical Industries, Ltd.), ST-40 (available from Nissan Chemical Industries, Ltd.), ST-C (Nissan Chemical Industries, Ltd.), ST-N (Nissan Chemical Industries, Ltd.), ST-O (Nissan Chemical Industries, Ltd.), ST-50 (Nissan Chemical Industries, Ltd.), and ST-OL (Nissan Chemical Industries, Ltd.).

Examples of the commercially available fine particulate powdery silica include AEROSIL 130 (available from NIPPON AEROSIL CO., LTD.), AEROSIL 300 (NIPPON AEROSIL CO., LTD.), AEROSIL 380 (NIPPON AEROSIL CO., LTD.), AEROSIL TT600 (NIPPON AEROSIL CO., LTD.), and AEROSIL OX50 (NIPPON AEROSIL CO. , LTD.), SILDEX H31 (available from Asahi Glass Co. , Ltd.), SILDEX H32 (Asahi Glass Co. , Ltd.), SILDEX H51 (Asahi Glass Co. , Ltd.), SILDEX H52 (Asahi Glass Co., Ltd.), SILDEX H121 (Asahi Glass Co., Ltd.), and SILDEX H122 (Asahi Glass Co., Ltd.), E220A (available from Nippon Silica Ind. Co., Ltd.) and E220 (Nippon Silica Ind. Co. , Ltd.), SYLYSIA 470 (available from Fuj i Silysia K.K.), SG flake (available from Nippon Sheet Glass Co., Ltd.).

### (Triazine UV absorber)

The triazine UV absorber is represented by the following Formula (I):

Q¹-Q²-OH Formula (I)

wherein Q¹ represents a 1,3,5-triazine ring, and Q² represents an aromatic ring, preferably a benzene ring.

More preferred for Formula (I) is a compound represented by General formula (I-A):

[Chemical formula 1]

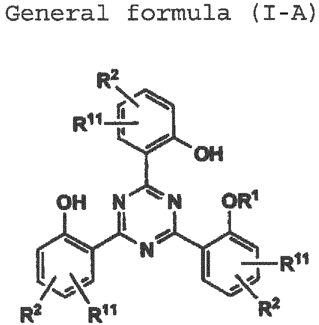

In the formula, R¹ represents an alkyl group having 1 to 18 carbon atoms; a cycloalkyl group having 5 to 12 carbon atoms; an alkenyl group having 3 to 18 carbon atoms; a phenyl group; an alkyl group having 1 to 18 carbon atoms substituted by a phenyl group, a hydroxy group, an alkoxy group having 1 to 18 carbon atoms, a cycloalkoxy group having 5 to 12 carbon atoms, an alkenyloxy group having 3 to 18 carbon atoms, a halogen atom, -COOH, -COOR⁴, -O-CO-R⁵, -O-CO-O-R⁶, -CO-NH₂, -CO-NHR⁷, -CO-N(R⁷) (R⁸), CN, NH₂, NHR⁷, -N(R⁷)(R⁸), -NH-CO-R⁵, a phenoxy group, a phenoxy group substituted by an alkyl group having 1 to 18 carbon atoms, a phenyl-alkoxy group having 1 to 4 carbon atoms, a bicycloalkoxy group having 6 to 15 carbon atoms, a bicycloalkylalkoxy group having 6 to 15 carbon atoms, a bicycloalkenylalkoxy group having 6 to 15 carbon atoms, or a tricycloalkoxy group having 6 to 15 carbon atoms; a cycloalkyl group having 5 to 12 carbon atoms substituted by a hydroxy group, an alkyl group having 1 to 4 carbon atoms, an alkenyl group having 2 to 6 carbon atoms or -O-CO-R⁵; a glycidyl group;-CO-R⁹ or -SO₂-R¹⁰ or R¹ represents an alkyl group having 3 to 50 carbon atoms, interrupted by at least one oxygen atom and/or substituted by a hydroxy group, a phenoxy group, or an alkylphenoxy group having 7 to 18 carbon atoms; or R¹ represents one of the definitions represented by -A; -CH₂-CH(XA) -CH₂-O-R¹²; -CR¹³R'¹³- (CH₂)ₘ-X-A; -CH₂-CH(OA)-R¹⁴; -CH₂-CH(OH)-CH₂-XA;

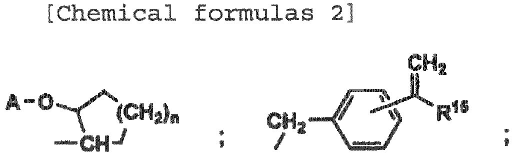

-CR¹⁵R'¹⁵-C(=CH₂)-R"¹⁵; -CR¹³R'¹³-(CH₂)ₘ-CO-X-A; -CR¹³R'¹³-(CH₂)ₘ-CO-O-CR¹⁵R'¹⁵-C(=CH₂)-R"¹⁵ or -CO-O-CR¹⁵R'¹⁵-C(=CH₂)-R"¹⁵ (wherein A represents -CO-CR¹⁶=CH-R¹⁷).

R²s each independently represent an alkyl group having 6 to 18 carbon atoms; an alkenyl group having 2 to 6 carbon atoms; a phenyl group; a phenylalkyl group having 7 to 11 carbon atoms; COOR⁴; CN; -NH-CO-R⁵; a halogen atom; a trifluoromethyl group; or -O-R³.

R³ has the definition as given for R¹.

R⁴ represents an alkyl group having 1 to 18 carbon atoms; an alkenyl group having 3 to 18 carbon atoms; a phenyl group; a phenylalkyl group having 7 to 11 carbon atoms; or a cycloalkyl group having 5 to 12 carbon atoms; or R⁴ represents an alkyl group having 3 to 50 carbon atoms, interrupted by at least one -O-, -NH-, -NR⁷-, or -S-, and optionally substituted by OH, a phenoxy group, or an alkylphenoxy group having 7 to 18 carbon atoms.

R⁵ represents H; an alkyl group having 1 to 18 carbon atoms; an alkenyl group having 2 to 18 carbon atoms; a cycloalkyl group having 5 to 12 carbon atoms; a phenyl group; a phenylalkyl group having 7 to 11 carbon atoms; a bicycloalkyl group having 6 to 15 carbon atoms; a bicycloalkenyl group having 6 to 15 carbon atoms; or a tricycloalkyl group having 6 to 15 carbon atoms.

R⁶ represents H; an alkyl group having 1 to 18 carbon atoms; an alkenyl group having 3 to 18 carbon atoms; a phenyl group; a phenylalkyl group having 7 to 11 carbon atoms; or a cycloalkyl group having 5 to 12 carbon atoms.

R⁷ and R⁸ each independently represent an alkyl group having 1 to 12 carbon atoms; an alkoxyalkyl group having 3 to 12 carbon atoms; or a dialkylaminoalkyl group having 4 to 16 carbon atoms; or represent a cycloalkyl group having 5 to 12 carbon atoms; or R⁷ and R⁸ taken together represent an alkylene group having 3 to 9 carbon atoms, an oxaalkylene group having 3 to 9 carbon atoms or an azaalkylene group having 3 to 9 carbon atoms.

R⁹ represents an alkyl group having 1 to 18 carbon atoms; an alkenyl group having 2 to 18 carbon atoms; a phenyl group; a cycloalkyl group having 5 to 12 carbon atoms; a phenylalkyl group having 7 to 11 carbon atoms; a bicycloalkyl group having 6 to 15 carbon atoms; a bicycloalkylalkyl group having 6 to 15 carbon atoms, a bicycloalkenyl group having 6 to 15 carbon atoms; or a tricycloalkyl group having 6 to 15 carbon atoms.

R¹⁰ represents an alkyl group having 1 to 12 carbon atoms; a phenyl group; a naphthyl group; or an alkylphenyl group having 7 to 14 carbon atoms.

R¹¹s each independently represent H; an alkyl group having 1 to 18 carbon atoms; an alkenyl group having 3 to 6 carbon atoms; a phenyl group; a phenylalkyl group having 7 to 11 carbon atoms; a halogen atom; an alkoxy group having 1 to 18 carbon atoms.

R¹² represents an alkyl group having 1 to 18 carbon atoms; an alkenyl group having 3 to 18 carbon atoms; a phenyl group; or a phenyl group substituted once to three times by an alkyl group having 1 to 8 carbon atoms, an alkoxy group having 1 to 8 carbon atoms, an alkenyloxy group having 3 to 8 carbon atoms, a halogen atom or a trifluoromethyl group; or a phenylalkyl group having 7 to 11 carbon atoms; a cycloalkyl group having 5 to 12 carbon atoms; a tricycloalkyl group having 6 to 15 carbon atoms; a bicycloalkyl group having 6 to 15 carbon atoms; a bicycloalkylalkyl group having 6 to 15 carbon atoms; a bicycloalkenylalkyl group having 6 to 15 carbon atoms; or -CO-R⁵; or R¹² represents an alkyl group having 3 to 50 carbon atoms, interrupted by at least one -O-, -NH-, -NR⁷-, or -S-, and optionally substituted by OH, a phenoxy group, or an alkylphenoxy group having 7 to 18 carbon atoms.

R¹³ and R'¹³ each independently represent H; an alkyl group having 1 to 18 carbon atoms; a phenyl group.

R¹⁴ represents an alkyl group having 1 to 18 carbon atoms; an alkoxyalkyl group having 3 to 12 carbon atoms; a phenyl group; or a phenyl-alkyl group having 1 to 4 carbon atoms.

R¹⁵, R'¹⁵ and R"¹⁵ each independently represent H or CH₃.

R¹⁶ represents H; -CH₂-COO-R⁴; an alkyl group having 1 to 4 carbon atoms; or CN.

R¹⁷ represents H; -COOR⁴; an alkyl group having 1 to 17 carbon atoms; or a phenyl group.

X represents -NH-; -NR⁷-; -O-; -NH-(CH₂)ₚ-NH-; or -O-(CH₂)_{q}-NH-.

The indices m, n, p, and q represent a numeral of 0 to 19, a numeral of 1 to 8, a numeral of 0 to 4, and a numeral of 2 to 4 respectively.

Note that in Formula (I-A), at least one of R¹, R² and R¹¹ has two or more carbon atoms.

The amount of the triazine UV absorber used is preferably 0.1 to 10% by mass on the basis of the total mass of the hard coat layer. An amount of 10% by mass or less leads to favorable adhesion, and an amount of 1% by mass or more contributes to a significant reduction in the deterioration caused by sunlight.

### (Inorganic UV absorber)

The inorganic UV absorber, preferably a metal oxide pigment, is a compound that, when dispersed in a concentration of 20% or more by mass in an acrylic resin to form a 6-*µ*m-thick film, has a function to decrease the light transmittance of the film in the UV-B range (290 to 320 nm) to 10% or less. The inorganic UV absorber that can be used in the present invention is preferably selected from titanium oxide, zinc oxide, iron oxides, cerium oxides or mixtures thereof in particular.

From the viewpoint of improving the transparency of an inorganic UV absorber-containing layer, the inorganic UV absorber is also a particulate metal oxide that preferably has an average primary particle size as a number average particle size between 5 nm and 150 nm, and more preferably between 10 nm and 100 nm, and has a maximum particle size of 150 nm or less in its particle size distribution. Such a type of coated or non-coated metal oxide pigment is described in more detail in Patent Application Publication No. EP-A-0 518 773.

Examples of the commercially available inorganic UV absorber include Sicotrans Red L2815 (iron oxide; available from BASF), CeO-X01 (cerium oxide; available from IOX Co. , Ltd.), NANOFINE-50 (zinc oxide; available from Sakai Chemical Industry Co., Ltd.), STR-60 (titanium oxide; Sakai Chemical Industry Co., Ltd.), CM-1000 (iron oxide; available from Chemirite, Ltd.), CERIGUARD S-3018-02 (cerium oxide; available from DAITO KASEI KOGYO CO., LTD.), MZ-300 (zinc oxide; available from Tayca Corporation), MT-700B (titanium oxide; Tayca Corporation).

The particle size of the inorganic UV absorber can be measured with a dynamic light scattering particle size distribution analyzer LB-550 (available from HORIBA, Ltd.), and the number average particle size can be determined from the output of the measurement results.

The amount of the inorganic UV absorber used is preferably 1 to 50% by mass, more preferably 5 to 25% by mass, and most preferably 15 to 20% by mass on the basis of the total mass of the hard coat layer. An amount of 50% by mass or less leads to favorable adhesion, and an amount of 1% by mass or more contributes to a significant reduction in the deterioration caused by sunlight.

In a combined use of the inorganic UV absorber with an organic UV absorber described below, the amount of the inorganic UV absorber used is 3 to 20% by mass, and preferably 5 to 10% by mass, and the amount of the organic UV absorber used is 0.1 to 10% by mass, and preferably 0.5 to 5% by mass, each of which is on the basis of the total mass of the UV absorbing layer. The combined use of the inorganic UV absorber with the organic UV absorber in the range of the amounts mentioned above enables the UV absorbing layer to exhibit high transparency and high weather resistance.

### (Coating layer)

In the present invention, from the viewpoint of reducing an oxidative degradation effect by the photo-catalytic activity of the inorganic oxide on the adjoining resin, the inorganic UV absorber is preferably a fine particulate inorganic UV absorber that has a coating layer on its surface, and a number average particle size (including a coating layer) of 10 nm or more and 100 nm or less. The coating layer also has an effect of improving dispersion of the particulate inorganic UV absorber; therefore, the particulate inorganic UV absorber having a coating layer is more preferably used. The coating layer mentioned herein can contain compounds such as amino acids, beeswax, fatty acids, fatty alcohols, anionic surfactants, lecithin, sodium, potassium, zinc, iron or aluminium salts of fatty acids, metal (titanium or aluminium) alkoxides, polyethylenes, silicones, proteins (collagen, elastin), alkanolamines, silicon oxides, metal oxides, and sodium hexametaphosphate, and can be formed on the inorganic UV absorber by one or more of the chemical, electronic, mechanochemical and mechanical means.

### (Antioxidant)

In order to prevent the adhesion of the interface between the hard coat layer and its adjoining resin layer from degrading by irradiation with sunlight, the hard coat layer preferably contains an antioxidant.

The antioxidant that can be used in the present invention can be selected from the antioxidant group consisting of hindered phenol compounds, hindered amine compounds, and phosphorus compounds. Among them, preferred are hindered amine compounds.

The antioxidant is preferably contained in an amount of 0.1 to 5% by mass on the basis of the total mass of the hard coat layer. An amount of 0.1% by mass or more leads to a reduction in oxidative cleavage of the resin chains and decomposition of the UV absorber, and an amount of 5% by mass or less contributes to favorable adhesion.

### (Hindered phenol compound)

Specific examples of the hindered phenol compounds include n-octadecyl 3-(3,5-di-t-butyl-4-hydroxyphenyl)-propionate, n-octadecyl 3-(3,5-di-t-butyl-4-hydroxyphenyl)-acetate, n-octadecyl 3,5-di-t-butyl-4-hydroxybenzoate, n-hexyl 3,5-di-t-butyl-4-hydroxyphenylbenzoate, n-dodecyl 3,5-di-t-butyl-4-hydroxyphenylbenzoate, neo-dodecyl 3-(3,5-di-t-butyl-4-hydroxyphenyl)propionate, dodecyl β(3,5-di-t-butyl-4-hydroxyphenyl)propionate, ethyl α-(4-hydroxy-3,5-di-t-butylphenyl)isobutyrate, octadecyl α-(4-hydroxy-3,5-di-t-butylphenyl)isobutyrate, octadecyl α-(4-hydroxy-3,5-di-t-butyl-4-hydroxyphenyl)propionate, 2-(n-octylthio)ethyl 3,5-di-t-butyl-4-hydroxy-benzoate, 2-(n-octylthio)ethyl 3,5-di-t-butyl-4-hydroxy-phenylacetate, 2-(n-octadecylthio)ethyl 3,5-di-t-butyl-4-hydroxyphenylacetate, 2-(n-octadecylthio)ethyl 3,5-di-t-butyl-4-hydroxy-benzoate, 2-(2-hydroxyethylthio)ethyl 3,5-di-t-butyl-4-hydroxybenzoate, diethylglycol bis-(3,5-di-t-butyl-4-hydroxy-phenyl)propionate, 2-(n-octadecylthio)ethyl 3-(3,5-di-t-butyl-4-hydroxyphenyl)propionate, stearamido N,N-bis-[ethylene3-(3,5-di-t-butyl-4-hydroxyphenyl)propiona te], n-butylimino N,N-bis-[ethylene3-(3,5-di-t-butyl-4-hydroxyphenyl)propiona te], 2-(2-stearoyloxyethylthio)ethyl 3,5-di-t-butyl-4-hydroxybenzoate, 2-(2-stearoyloxyethylthio)ethyl 7-(3-methyl-5-t-butyl-4-hydroxyphenyl)heptanoate, 1,2-propylene glycol bis-[3-(3,5-di-t-butyl-4-hydroxyphenyl)propionate], ethylene glycol bis-[3-(3,5-di-t-butyl-4-hydroxyphenyl)propionate], neopentyl glycol bis-[3-(3,5-di-t-butyl-4-hydroxyphenyl)propionate], ethylene glycol bis-(3,5-di-t-butyl-4-hydroxyphenylacetate), glycerin-1-n-octadecanoate -2,3-bis-(3,5-di-t-butyl-4-hydroxyphenylacetate), pentaerythritol tetrakis-[3-(3',5'-di-t-butyl-4'-hydroxyphenyl)propionate], 3,9-bis-{2-[3-(3-tert-butyl-4-hydroxy-5-methylphenyl)propio nyloxy]-1,1-dimethylethyl}-2,4,8,10-tetraoxaspiro[5.5]undec ane, 1,1,1-trimethylolethane-tris-[3-(3,5-di-t-butyl-4-hydroxyph enyl)propionate], sorbitol hexa-[3-(3,5-di-t-butyl-4-hydroxyphenyl)propionate], 2-hydroxyethyl 7-(3-methyl-5-tbutyl-4-hydroxyphenyl)propionate, 2-stearoyloxyethyl 7-(3-methyl-5-t-butyl-4-hydroxyphenyl)heptanoate, 1,6-n-hexanediol-bis[(3',5'-di-t-butyl-4-hydroxyphenyl)prop ionate], and pentaerythritol tetrakis(3,5-di-t-butyl-4-hydroxyhydrocinnamate). For example, this type of the phenolic compounds are commercially available under the trade names of "IRGANOX 1076" and "IRGANOX 1010" from Ciba Japan K.K.

### (Hindered amine compound)

Specific examples of the hindered amine compounds include bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, bis(N-octoxy-2,2,6,6-tetramethyl-4-piperidyl) sebacate, bis(N-benzyloxy-2,2,6,6-tetramethyl-4-piperidyl) sebacate, bis(N-cyclohexyloxy-2,2,6,6-tetramethyl-4-piperidyl) sebacate, bis(1,2,2,6,6-pentamethyl-4-piperidyl) 2-(3,5-di-t-butyl-4-hydroxybenzyl)-2-butylmalonate, bis(1-acryloyl-2,2,6,6-tetramethyl-4-piperidyl) 2,2-bis(3,5-di-t-butyl-4-hydroxybenzyl)-2-butylmalonate, bis(1,2,2,6,6-pentamethyl-4-piperidyl) decanedioate, 2,2,6,6-tetramethyl-4-piperidyl methacrylate, 4-[3-(3,5-di-t-butyl-4-hydroxyphenyl)propionyloxy]-1-[2-(3-(3,5-di-t-butyl-4-hydroxyphenyl)propionyloxy)ethyl]-2,2,6,6 -tetramethylpiperidine, 2-methyl-2-(2,2,6,6-tetramethyl-4-piperidyl)amino-N-(2,2,6, 6-tetramethyl-4-piperidyl)propionamide, tetrakis(2,2,6,6-tetramethyl-4-piperidyl) 1,2,3,4-butanetetracarboxylate, and tetrakis(1,2,2,6,6-pentamethyl-4-piperidyl) 1,2,3,4-butanetetracarboxylate.

The hindered amine compounds may be polymeric compounds. Specific but non-limiting examples of the polymeric compounds include high molecular weight HALS in which a plurality of piperidine rings are linked via a triazine skelton, such as N,N',N",N'''-tetrakis-[4,6-bis-[butyl-(N-methyl-2,2,6,6-tet ramethylpiperidine-4-yl)amino]-triazine-2-yl]-4,7-diazadeca ne-1,10-diamine, polycondensates of dibutylamine, 1,3,5-triazine-N,N'-bis(2,2,6,6-tetramethyl-4-piperidyl)-1, 6-hexamethylenediamine and N-(2,2,6,6-tetramethyl-4-piperidyl)butylamine, polycondensates of dibutylamine, 1,3,5-triazine, and N,N'-bis(2,2,6,6-tetramethyl-4-piperidyl)butylamine, poly[{(1,1,3,3-tetramethylbutyl)amino-1,3,5-triazine-2,4-di yl}{(2,2,6,6-tetramethyl-4-piperidyl)imino}hexamethylene{(2 ,2,6,6-tetramethyl-4-piperidyl)imino}], polycondensates of 1,6-hexanediamine-N,N'-bis(2,2,6,6-tetramethyl-4-piperidyl) and morpholine-2,4,6-trichloro-1,3,5-triazine, and poly[(6-morpholino-s-triazine-2,4-diyl)[(2,2,6,6,-tetrameth yl-4-piperidyl)imino]-hexamethylene[(2,2,6,6-tetramethyl-4-piperidyl) imino]] ; and compounds in which piperidine rings are linked via an ester bond, such as polymerization products of dimethyl succinate and 4-hydroxy-2,2,6,6-tetramethyl-1-piperidineethanol, and mixed-esterification products of 1,2,3,4-butanetetracarboxylic acid, 1,2,2,6,6-pentamethyl-4-piperidinol and 3,9-bis(2-hydroxy-1,1-dimethylethyl)-2,4,8,10-tetraoxaspiro [5,5]undecane.

Among them, preferred are polycondensates of dibutylamine, 1,3,5-triazine, and N,N'-bis(2,2,6,6-tetramethyl-4-piperidyl)butylamine; poly[{(1,1,3,3-tetramethylbutyl)amino-1,3,5-triazine-2,4-di yl}{(2,2,6,6-tetramethyl-4-piperidyl)imino}hexamethylene{(2 ,2,6,6-tetramethyl-4-piperidyl)imino}]; and polymerization products of dimethyl succinate and 4-hydroxy-2,2,6,6-tetramethyl-1-piperidineethanol, each of which have a number average molecular weight (Mn) of 2,000 to 5,000.

The above types of the hindered amine compounds are commercially available under the trade names of "TUNUVIN 144" and "TUNUVIN 770" from Ciba Japan K.K., and the trade name of "ADK STAB LA-52" from ADEKA CORPORATION, for example.

The hindered amine compound is preferably contained in an amount of 0.1 to 5% by mass on the basis of the total mass of the hard coat layer. An amount of 0.1% by mass or more leads to a reduction in oxidative cleavage of the resin chain and decomposition of the UV absorber, and an amount of 5% by mass or less contributes to favorable adhesion.

### (Phosphorus compound)

Specific examples of the phosphorus compounds include monophosphite compounds such as triphenyl phosphite, diphenyl isodecyl phosphite, phenyl diisodecyl phosphite, tris(nonylphenyl) phosphite, tris(dinonylphenyl) phosphite, tris(2,4-di-t-butylphenyl) phosphite, 10-(3,5-di-t-butyl-4-hydroxybenzyl)-9,10-dihydro-9-oxa-10-p hosphaphenanthrene-10-oxide, 6-[3-(3-t-butyl-4-hydroxy-5-methylphenyl)propoxy]-2,4,8,10-tetra-t-butyldibenz[d,f][1,3,2]dioxaphosphepin, and tridecylphosphite; diphosphite compounds such as 4,4'-butylidene-bis(3-methyl-6-t-butylphenyl-di-tridecylpho sphite) and 4,4'-isopropylidene-bis(phenyl-di-alkyl(C₁₂ to C₁₅)phosphite); phosphonite compounds such as triphenylphosphonite, tetrakis(2,4-di-tert-butylphenyl)[1,1-biphenyl]-4,4'-diyl bisphosphonite and tetrakis(2,4-di-tert-butyl-5-methylphenyl)[1,1-biphenyl]-4, 4'-diyl bisphosphonite; phosphinite compounds such as triphenyl phosphinite and 2,6-dimethylphenyl diphenyl phosphinite; and phosphine compounds such as triphenyl phosphine and tris(2,6-dimethoxyphenyl) phosphine.

The above types of phosphorus compounds are commercially available under the trade name of "Sumilizer GP" from Sumitomo Chemical Co. , Ltd., the trade names of "ADK STAB PEP-24G", "ADK STAB PEP-36" and "ADK STAB 3010" from ADEKA CORPORATION, "IRGAFOS P-EPQ" from Ciba Japan K.K., and "GSY-P101" from Sakai Chemical Industry Co., Ltd., for example.

### (Resin layer)

The resin layer is disposed adjoining the hard coat layer.

The resin layer may be a corrosion inhibiting layer containing a corrosion inhibitor, a UV absorbing layer containing a UV absorber, or a bond layer for improving the adhesion between the hard coat layer and the other layer. The UV absorbing layer may be a resin film containing a UV absorber. Preferably, the hard coat layer is disposed on one side of the resin film, while a film including a reflective layer is bonded onto the other side with an adhesive. Examples of the resin to be used in the resin film include polyester resins, polycarbonate resins, and acrylic resins. Among them, preferred are acrylic resins.

In the case where the resin layer contains a UV absorber, triazine compounds, triazole compounds, and inorganic compounds can be used as the UV absorber.

### (Corrosion inhibiting layer)

The corrosion inhibiting layer is disposed for preventing corrosion of the reflective layer.

The corrosion inhibiting layer is preferably composed of a resin layer containing a corrosion inhibitor, more preferably of a resin layer containing 0.01 to 10% by mass of corrosion inhibitor.

Examples of the resin to be used in the corrosion inhibiting layer according to the present invention include polyester resins, acrylic resins, melamine resins, epoxy resins, polyamide resins, vinyl chloride resins, and vinyl chloride-vinyl acetate copolymer resins, which can be used alone or in combination, and preferred are mixed resins of polyester resins and melamine resins from the viewpoint of weathering resistance. More preferred is to further mix with a curing agent such as an isocyanate to form thermosetting resins.

The thickness of the corrosion inhibitor layer according to the present invention is preferably 0.01 to 3 µm, and more preferably 0.1 to 1 µm from the viewpoint of the adhesion , the flatness, and the reflectance of reflective materials.

The corrosion inhibitor layer can be formed by any conventional coating process, such as gravure coating, reverse coating, or die coating.

### (Corrosion inhibitor)

In the case of a silver reflective layer, preferred corrosion inhibitors to be used in the corrosion inhibiting layer according to the present invention are inhibitors and antioxidants having a group adsorptive to silver.

The term "corrosion" as used here refers to a phenomenon of chemical or electrochemical erosion or material degradation of metal (e.g., silver) by environmental substances (see JIS Z0103-2004).

Furthermore, a preferred amount of the corrosion inhibitor is typically in the range of 0.1 to 1.0 g/m², whereas an optimum amount of the inhibitor may vary depending on the type of the inhibitor used.

(Corrosion inhibitor having group adsorptive to silver)
The corrosion inhibitor having a group adsorptive to silver is preferably at least one compound selected from at least one of amines and derivatives thereof, compounds having pyrrole rings, compounds having triazole rings, compounds having pyrazole rings, compounds having thiazole rings, compounds having imidazole rings, compounds having indazole rings, copper chelate compounds, thioureas, compounds having mercapto groups, and naphthalene compounds, and mixtures thereof.

### (Reflective layer)

The reflective layer has a function to reflect incident sunlight with high reflectance. The reflective layer is preferably composed of metal, which can result in higher reflectance. Preferred is a reflective layer composed of silver, among other metals.

The silver reflective layer can be formed by any wet or dry process.

The wet process is a collective name for plating, which is a process of depositing metal from a solution to form a silver film, and is, for example, a silver mirror reaction.

The dry process is a collective name for vacuum deposition of a film, and examples thereof includes resistance heating vacuum deposition, electron beam heating vacuum deposition, ion plating, ion-beam assisted vacuum deposition, and sputtering. Particularly, a deposition by which a film can be continuously deposited in a roll-to-roll way is preferably used in the present invention.

The silver reflective layer according to the present invention preferably has a thickness of 10 to 200 nm, and more preferably 30 to 150 nm in view of reflectance.

In the present invention, the silver reflective layer may be disposed either on a light-incident side or the opposite side of the resin substrate. Preferably, since the substrate is composed of resin, the silver reflective layer is disposed on the light-incident side of the substrate for the purpose of preventing photodegradation of the resin in the substrate.

### (Substrate)

The substrate is composed of resin, and may be any known resin film.

Examples of the resin films include polyester films such as cellulose ester films, polyester films, polycarbonate films, polyarylate films, polysulphone (including polyether sulfone) films, polyethylene terephthalates, and polyethylene naphthalates, and polyethylene films, polypropylene films, cellophanes, cellulose diacetate films, cellulose triacetate films, cellulose acetate propionate films, cellulose acetate butyrate films, polyvinylidene dichloride films, polyvinyl alcohol films, ethylene vinyl alchohol films, syndiotactic polystyrene films, polycarbonate films, norbornene resin films, polymethylpentene films, polyether ketone films, polyether ketone imide films, polyamide films, fluororesin films, nylon films, polymethyl methacrylate films, and acrylic films.

Among them, preferred are polycarbonate films, polyester films, norbornene resin films, and cellulose ester films. In particular, preferred are polyester films and cellulose ester films, which may be formed by a melt casting process or a solution casting process.

The resin substrate is preferably adjusted into an appropriate thickness depending on the type and the purpose of the resin. For example, the thickness is generally in the range of 10 to 300 µm, preferably of 20 to 200 µm, and more preferably of 30 to 100 µm.

### EXAMPLES

The present invention will now be specifically described with reference to examples, but the present invention should not be limited thereto. Note that "parts" and "%" which are used in the examples indicate "parts by mass" and "% by mass" , respectively, unless otherwise specified.

### «Preparation of reflection device for solar thermal power generation»

### [Preparation of Sample 1]

A biaxially oriented polyester film (polyethylene terephthalate film having a thickness of 100 µm) was used as a resin substrate. A mixed resin of ESPEL 9940A (available from Hitachi Chemical Co., Ltd.) as a polyester resin, a melamine resin, tolylene diisocyanate (TDI) as a diisocyanate cross-linking agent, and hexamethylene diisocyanate (HMDI) (available from MITSUI FINE CHEMICAL Inc.) in a mass ratio of 20:1:1:2 was applied onto one side of the polyethylene terephthalate film by gravure coating to form an anchor layer having a thickness of 0.1 µm, and then a silver reflective layer having a thickness of 80 nm was formed by a known vacuum deposition process. Onto this silver reflective layer, a mixed resin of ESPEL 9940A and tolylene diisocyanate in a mass ratio of 10:2 on the resin solid content basis to which Tinuvin 234 (available from Ciba Japan K.K.) was added as a corrosion inhibitor in an amount of 10% by mass on the basis of the resin solid content was applied by gravure coating to form a corrosion inhibiting layer having a thickness of 0.1 µm.

Subsequently, Vinylol 92T (acrylic resin bond; available from SHOWA HIGHPOLYMER CO., LTD.) was applied onto the corrosion inhibiting layer as a bond layer having a thickness of 10 µm, and an acrylic resin film containing a UV absorber (KORAD CLRAR05005, available from Polymer Excluded Product) having a thickness of 50 µm was laminated onto the bond layer. Then, LIODURAS LCH (UV-curable acrylic resin; available from TOYO INK CO., LTD.) to which Tinuvin 477 (Ciba Japan K.K.) as a triazine UV absorber in an amount of 0.05% by mass on the basis of the resin solid content and NANOFINE-50 (zinc oxide; number average particle size 20 nm; Sakai Chemical Industry Co., Ltd.) as an inorganic UV absorber in an amount of 10% by mass on the basis of the resin solid content were added was applied in a wet thickness of 40 µm onto the acrylic resin film by gravure coating to form a hard coat layer by UV irradiation using a UV conveyor (light source; high pressure mercury lamp, intensity of the light;100 mW/cm²). A film mirror for solar thermal power generation was thus prepared.

Furthermore, SE-6010 (acrylic resin adhesive; available from SHOWA HIGHPOLYMER CO., LTD.) was applied on the substrate resin to form an adhesive layer having a thickness of 10 µm. The above sample was bonded on a 0.1 mm thick x 4 cm long x 5 cm wide aluminum plate (available from Sumitomo Light Metal Industries, Ltd.) with the adhesive layer therebetween to prepare a sample 1, which is a reflection device for solar thermal power generation.

### [Preparation of Sample 2]

A reflection device for solar thermal power generation, Sample 2, was prepared in the same manner as Sample 1 except that Tinuvin 477 was added to the hard coat layer in an amount of 0.1% by mass on the basis of the resin solid content.

### [Preparation of Sample 3]

A reflection device for solar thermal power generation, Sample 3, was prepared in the same manner as the sample 1 except that Tinuvin 477 was added to the hard coat layer in an amount of 1.5% by mass on the basis of the resin solid content.

### [Preparation of Sample 4]

A reflection device for solar thermal power generation, Sample 4, was prepared in the same manner as sample 1 except that Tinuvin 477 was added to the hard coat layer in an amount of 6.5% by mass on the basis of the resin solid content.

### [Preparation of Sample 5]

A reflection device for solar thermal power generation, sample 5, was prepared in the same manner as Sample 1 except that Tinuvin 477 was added to the hard coat layer in an amount of 10.0% by mass on the basis of the resin solid content.

### [Preparation of Sample 6]

A reflection device for solar thermal power generation, Sample 6, was prepared in the same manner as Sample 1 except that Tinuvin 477 was added to the hard coat layer in an amount of 11.0% by mass on the basis of the resin solid content.

### [Preparation of Sample 7]

A reflection device for solar thermal power generation, Sample 7, was prepared in the same manner as Sample 2 except that NANOFINE-50 was added to the hard coat layer in an amount of 25% by mass on the basis of the resin solid content.

### [Preparation of Sample 8]

A reflection device for solar thermal power generation, Sample 8, was prepared in the same manner as Sample 3 except that NANOFINE-50 was added to the hard coat layer in an amount of 25% by mass on the basis of the resin solid content.

### [Preparation of Sample 9]

A reflection device for solar thermal power generation, Sample 9, was prepared in the same manner as Sample 4 except that NANOFINE-50 was added to the hard coat layer in an amount of 25% by mass on the basis of the resin solid content.

### [Preparation of Sample 10]

A reflection device for solar thermal power generation, Sample 10, was prepared in the same manner as Sample 5 except that NANOFINE-50 was added to the hard coat layer in an amount of 25% by mass on the basis of the resin solid content.

### [Preparation of Sample 11]

A reflection device for solar thermal power generation, Sample 11, was prepared in the same manner as Sample 2 except that NANOFINE-50 was added to the hard coat layer in an amount of 40% by mass on the basis of the resin solid content.

### [Preparation of Sample 12]

A reflection device for solar thermal power generation, Sample 12, was prepared in the same manner as Sample 3 except that NANOFINE-50 was added to the hard coat layer in an amount of 40% by mass on the basis of the resin solid content.

### [Preparation of Sample 13]

A reflection device for solar thermal power generation, Sample 13, was prepared in the same manner as Sample 4 except that NANOFINE-50 was added to the hard coat layer in an amount of 40% by mass on the basis of the resin solid content.

### [Preparation of Sample 14]

A reflection device for solar thermal power generation, Sample 14, was prepared in the same manner as Sample 5 except that NANOFINE-50 was added to the hard coat layer in an amount of 40% by mass on the basis of the resin solid content.

### [Preparation of Sample 15]

A reflection device for solar thermal power generation, Sample 15, was prepared in the same manner as Sample 2 except that Tinuvin 477 was not added to the hard coat layer but NANOFINE-50 was added to the hard coat layer in an amount of 25% by mass on the basis of the resin solid content.

### [Preparation of Sample 16]

A reflection device for solar thermal power generation, Sample 16, was prepared in the same manner as Sample 2 except that NANOFINE-50 was not added to the hard coat layer but Tinuvin 477 was added to the hard coat layer in an amount of 1.5% by mass on the basis of the resin solid content.

### [Preparation of Samples 17 to 19]

Reflection devices for solar thermal power generation, Samples 17, 18, and 19, were prepared in the same manner as Samples 3, 8, and 12, respectively except that a hindered amine compound, Tinuvin 152, as an antioxidant was added to the hard coat layer in an amount of 1% by mass on the basis of the resin solid content.

### [Preparation of Samples 20 to 23]

Reflection devices for solar thermal power generation, Samples 20 to 23, were prepared in the same manner as Sample 15 except that NANOFINE-50 added to the hard coat layer was replaced with inorganic UV absorbers having a number average particle size of 20 nm, i.e., Sicotrans Red L2815 (iron oxide; available from BASF), CeO-X01 (cerium oxide; available from IOX Co., Ltd.), NANOFINE-50 (zinc oxide; available from Sakai Chemical Industry Co., Ltd.), and STR-60 (titanium oxide; Sakai Chemical Industry Co., Ltd.) respectively in an amount of 15% by mass on the basis of the resin solid content as listed in Table 2.

### [Preparation of Samples 24 to 27]

Reflection devices for solar thermal power generation, Samples 24 to 27, were prepared in the same manner as Sample 15 except that NANOFINE-50 added to the hard coat layer was replaced with inorganic UV absorbers having a number average particle size of 150 nm, i.e., CM-1000 (iron oxide; available from Chemirite, Ltd.), CERIGUARD S-3018-02 (cerium oxide; available from DAITO KASEI KOGYO CO., LTD.), MZ-300 (zinc oxide; available from Tayca Corporation), and MT-700B (titanium oxide; available from Tayca Corporation) respectively in an amount of 15% by mass on the basis of the resin solid content as listed in Table 2.

### [Preparation of Samples 28 to 31]

Reflection devices for solar thermal power generation, Samples 28 to 31, were prepared in the same manner as Sample 15 except that NANOFINE-50 added to the hard coat layer was replaced with silica-coated inorganic UV absorbers having a number average particle size of 20 nm (inclusive the silica coating having a thickness of 5nm), i.e., Concelight BP-10S (iron oxide; available from JGC Catalysts and Chemicals Ltd.), CERIGUARDSC-6832 (cerium oxide; available from DAITO KASEI KOGYO CO., LTD.), FINEX-50W-LP2 (zinc oxide; available from Sakai Chemical Industry Co., Ltd.), and STR-100A-LP (titanium oxide; Sakai Chemical Industry Co., Ltd.) respectively in an amount of 15% by mass on the basis of the resin solid content as listed in Table 2.

### [Preparation of Sample 32]

A reflection device for solar thermal power generation, Sample 32, was prepared in the same manner as Sample 2 except that no UV absorbers was added the hard coat layer.

### [Preparation of Sample 33]

A reflection device for solar thermal power generation, Sample 33, was prepared in the same manner as Sample 32 except that Tinuvin 234 (available from Ciba Japan K.K.) as a benzotriazole UV absorber was added to the hard coat layer in an amount of 1.5% by mass on the basis of the resin solid content.

### [Preparation of Sample 34]

A reflection device for solar thermal power generation, Sample 34, was prepared in the same manner as Sample 32 except that Tinuvin 234 (available from Ciba Japan K.K.) as a benzotriazole UV absorber was added to the hard coat layer in an amount of 5% by mass on the basis of the resin solid content.

### «Evaluation of reflection device for solar thermal power generation»

Scratch resistance after wet-heat treatment and after UV degradation treatment was evaluated according to the following procedure for the reflection devices for solar thermal power generation prepared above.

### [Scratch resistance test after UV irradiation in a wet-heat environment (steel wool test)]

Each sample was irradiated with ultraviolet rays using an EYE SUPER UV TESTER available from IWASAKI ELECTRIC CO., LTD. in an environment of 65°C, a relative humidity of 60% for 96 hours followed by reciprocal rubbing by steel wool No. 0000 over the outermost surface of each sample under a load of 500 g/cm² with a stroke length of 50 mm and a speed of 500 mm/min. After 10 cycles of reciprocal rubbing, scratch resistance after wet heat treatment and after UV degradation treatment was evaluated in accordance with the following criteria.

⊚: 0 scratch
○: 1 to 5 scratches
Δ: 6-10 scratches
×: above 10 scratches

### [Specular reflectance measurement after UV irradiation in a wet-heat environment]

Each sample was irradiated with ultraviolet rays using an EYE SUPER UV TESTER available from IWASAKI ELECTRIC CO., LTD. in an environment of 65°C, a relative humidity of 60% for 96 hours followed by the following measurement.

With a modified U-4100 spectrophotometer (available from SHIMADZU CORPORATION) provided with an integrating sphere reflectance attachment, the incident angle of the incident light relative to the normal line of the reflective surface is adjusted to 5°, and specular reflectance at a reflection angle of 5° was measured for each sample. The specular reflectance was determined as an average of the observed reflectance values in the range of 400 nm to 700 nm, and the specular reflectance after UV degradation treatment was evaluated in accordance with the following criteria.
6: The average specular reflectance is 85% or more.
5: The average specular reflectance is 80% or more and less than 85%.
4: The average specular reflectance is 75% or more and less than 80%.
3 : The average specular reflectance is 70% or more and less than 75%.
2: The average specular reflectance is 65% or more and less than 70%.
1: The average specular reflectance is less than 65%.
Tables 1 and 2 show the measurement results.

**[Table 1-1]**

| Sample number | UV absorber | | | Antioxidant [% by mass] | Specular reflectance after deterioration | Steel wool test | Note |
|---|---|---|---|---|---|---|---|
| | Benzotriazole UV absorber [% by mass] | Triazine UV absorber by mass] | Zinc oxide [% by mass] | | | | |
| 1 | - | 0.05 | 10 | - | 4 | ○ | Present invention |
| 2 | - | 0.1 | 10 | - | 6 | ○ | Present invention |
| 3 | - | 1.5 | 10 | - | 6 | ○ | Present invention |
| 4 | - | 6.5 | 10 | - | 6 | ○ | Present invention |
| 5 | - | 10 | 10 | - | 6 | ○ | Present invention |
| 6 | - | 11 | 10 | - | 4 | ○ | Present invention |
| 7 | - | 0.1 | 25 | - | 5 | ○ | Present invention |
| 8 | - | 1.5 | 25 | - | 5 | ○ | Present invention |
| 9 | - | 6.5 | 25 | - | 4 | ○ | Present invention |
| 10 | - | 10 | 25 | - | 4 | ○ | Present invention |
| 11 | - | 0.1 | 40 | - | 4 | ○ | Present invention |

**[Table 1-2]**

| | UV absorber | | | | Specular reflectance after deterioration | | |
|---|---|---|---|---|---|---|---|
| Sample number | Benzotriazole UV absorber [% bv mass] | Triazine UV absorber [% by mass] | Zinc oxide [% by mass] | Antioxidant [% by mass] | | Steel wool test | Note |
| 12 | - | 1.5 | 40 | - | 4 | ○ | Present invention |
| 13 | - | 6.5 | 40 | - | 3 | ○ | Present invention |
| 14 | - | 10 | 40 | - | 3 | ○ | Present invention |
| 15 | - | 0 | 25 | - | 5 | ○ | Present invention |
| 16 | - | 1.5 | - | - | 6 | ○ | Present invention |
| 17 | - | 1.5 | 10 | 1 | 6 | ⊚ | Present invention |
| 18 | - | 1.5 | 25 | 1 | 5 | ⊚ | Present invention |
| 19 | - | - | 40 | 1 | 4 | ⊚ | Present invention |
| 32 | - | - | - | - | 2 | × | Comperative Example |
| 33 | 1.5 | - | - | - | 2 | × | Comperative Example |
| 34 | 5 | - | - | - | 1 | × | Comperative Example |

**[Table 2]**

| | UV absorber | | | Specular reflectance after deterioration | | |
|---|---|---|---|---|---|---|
| Sample number | Inorganic UV absorber | Number average particle diameter[nm] | content amount [% by mass] | | Steel wool test | Note |
| 20 | Iron oxide | 20 | 15 | 4 | ⊚ | Present invention |
| 21 | Cerium oxide | 20 | 15 | 4 | ⊚ | Present invention |
| 22 | Zinc oxide | 20 | 15 | 4 | ⊚ | Present invention |
| 23 | Titanium oxide | 20 | 15 | 4 | ○ | Present invention |
| 24 | Iron oxide | 150 | 15 | 3 | ○ | Present invention |
| 25 | Cerium oxide | 150 | 15 | 3 | ○ | Present invention |
| 26 | Zinc oxide | 150 | 15 | 3 | ○ | Present invention |
| 27 | Titanium oxide | 150 | 15 | 3 | Δ | Present invention |
| 28 | Silica-coated iron oxide | 20 | 15 | 5 | ⊚ | Present invention |
| 29 | Silica-coated cerium oxide | 20 | 15 | 5 | ⊚ | Present invention |
| 30 | Silica-coated zinc oxide | 20 | 15 | 5 | ⊚ | Present invention |
| 31 | Silica-coated titanium oxide | 20 | 15 | 5 | ○ | Present invention |

Tables 1 and 2 show that hard coat layers containing a triazine UV absorber or an inorganic UV absorber show a higher specular reflectance after irradiation with ultraviolet rays and a favorable scratch resistance after irradiation with ultraviolet rays than a hard coat layers containing a triazole UV absorber, where each of the hard coat layers is disposed in a film mirror for solar thermal power generation used in a reflection device for solar thermal power generation.

As described above, the film mirror for solar thermal power generation of the present invention can be used as a superior film mirror for solar thermal power generation, because this film mirror maintains a high specular reflectance without delamination between the layers after long-term irradiation with sunlight.
Note that techniques of the present invention can be applied to various functional films other than a film mirror for solar thermal power generation. Particularly, techniques of the present invention is preferably applied to functional films used outdoors such as thermal barrier films for outdoors, which can benefit from the effect of the present invention that no delamination between the layers occurs even after long-term irradiation with sunlight while the hard coat layer provides scratch resistance. Thermal barrier films preferably has a silver layer, and especially, a thickness of the silver layer is preferably in the range of 0.1 nm to 50 nm.

### INDUSTRIAL APPLICABILITY

The present invention configured as above is applicable to a film mirror for solar thermal power generation, a method for manufacturing the film mirror for solar thermal power generation, and a reflection device for solar thermal power generation using the film mirror for solar thermal power generation.

## Claims

1. A film mirror for solar thermal power generation comprising, in sequence:
a hard coat layer;
a resin layer; and
a reflective layer,
wherein the hard coat layer adjoins the resin layer, and the hard coat layer contains a triazine UV absorber or an inorganic UV absorber.

2. The film mirror for solar thermal power generation of claim 1, wherein the hard coat layer contains 0.1 to 5% by mass of an antioxidant on the basis of a resin solid content.

3. The film mirror for solar thermal power generation of claim 1 or 2, wherein the hard coat layer contains the triazine UV absorber and the inorganic UV absorber.

4. The film mirror for solar thermal power generation of any one of claims 1 to 3, wherein the hard coat layer contains 0.1 to 10% by mass of the triazine UV absorber on the basis of the resin solid content.

5. The film mirror for solar thermal power generation of any one of claims 1 to 4, wherein the hard coat layer contains 1 to 50% by mass of the inorganic UV absorber on the basis of the resin solid content, and the inorganic UV absorber is a titanium oxide, a zinc oxide, a cerium oxide or an iron oxide.

6. The film mirror for solar thermal power generation of any one of claims 1 to 5, wherein the inorganic UV absorber is a fine particulate absorber having a number average particle size of 10 nm to 100 nm.

7. The film mirror for solar thermal power generation of any one of claims 1 to 6, wherein a coating layer is disposed on the inorganic UV absorber.

8. The film mirror for solar thermal power generation of any one of claims 1 to 7, wherein the hard coat layer comprises a UV-cured acrylic resin.

9. The film mirror for solar thermal power generation of any one of claims 2 to 8, wherein the antioxidant is a hindered amine compound.

10. A method for manufacturing a film mirror for solar thermal power generation of any one of claims 1 to 9, the film mirror including the reflective layer, the method comprising:
forming the reflective layer by deposition of silver.

11. A reflection device for solar thermal power generation comprising the film mirror for solar thermal power generation of any one of claims 1 to 9, wherein the film mirror for solar thermal power generation is bonded to a metal support body through an adhesive layer.
